Europäisches Patentamt

European Patent Office

Office européen des brevets

(11) Publication number: **0 420 210 A2**

# EUROPEAN PATENT APPLICATION

(21) Application number: **90118502.5**

(22) Date of filing: **26.09.90**

(51) Int. Cl.5: **G01R 31/02**

(30) Priority: **29.09.89 JP 252340/89**

(43) Date of publication of application:
**03.04.91 Bulletin 91/14**

(84) Designated Contracting States:
**CH GB LI**

(71) Applicant: **TOSHIBA LIGHTING &
TECHNOLOGY CORPORATION
4-28, Mita 1-chome**

**Minato-ku Tokyo(JP)**

(72) Inventor: **Shibano, Nobuo
2638-78, Minamishitauramachikamimiyada
Miura-shi, Kanagawa-ken(JP)**

(74) Representative: **Henkel, Feiler, Hänzel &
Partner
Möhlstrasse 37
W-8000 München 80(DE)**

(54) **Lamp inoperable-state detecting circuit and large display apparatus equipped with the same.**

(57) An inoperable-state detecting circuit for use in a large display apparatus includes a digital lighting signal supplying circuit for sequentially supplying a digital lamp lighting signal to a plurality of lamps to sequentially turn on the lamps. Upon reception, from each lamp, of a lamp-check return signal indicating if this lamp is properly lit, a counter (21) counts by one and outputs a count value. A comparator (23) compares the count value of the counter (21) with a reference value and outputs a comparison result when supplying of the lamp lighting signal from the digital lighting signal supplying circuit is completed. A discrimination circuit (24, 27) is provided in the display apparatus, and digitally determines whether or not at least one of the lamps is inoperable based on the comparison result from the comparator (23).

F I G. 6

# LAMP INOPERABLE-STATE DETECTING CIRCUIT AND LARGE DISPLAY APPARATUS EQUIPPED WITH THE SAME

The present invention relates to a circuit for detecting an inoperable state of a lamp, and, more particularly, to a circuit for detecting an inoperable state of a lamp of a large display comprising a plurality of lamps.

Recently, a so-called large display or large video display device (large color vision) has been sited on ball parks and other sports fields or stadiums to display various images. This large display has a plurality of lamp modules arranged in a matrix pattern, each comprising a plurality of lamps also arranged in a matrix pattern. Since a large number of lamps are used, a special system is needed to detect an inoperable state of each lamp.

A conventional inoperable-state detecting system turns on the first lamp of each lamp module and determines whether or not the lamp is inoperable or normal based on the lamp current detected then. If the lamp is inoperable, such information is transmitted to a CPU of a control center that is monitoring the large display. This checking is done on every lamp included in each lamp module in order to detect an inoperable state of a lamp if any.

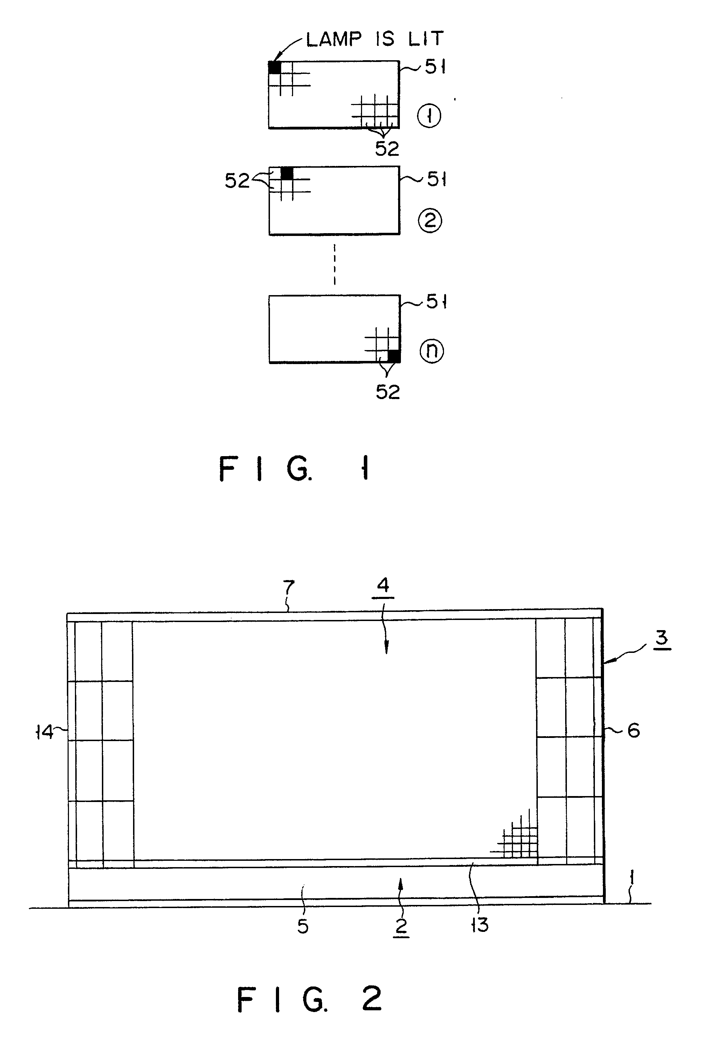

Fig. 1 is an exemplary diagram illustrating that an inoperable-state detection is sequentially executed for a plurality of lamps included in one lamp module. Referring to this diagram, reference numeral "51" denotes a lamp module and reference numeral "52" denotes each lamp. Those lamps 52 which are marked black are the turned-on or lit ones; in this manner, it is checked if a lamp in question is inoperable or normal. For instance, the inoperable-state detection starts with the upper left lamp of the lamp module 51 and continues to the next lamp on the right all the way down to the lower right one, as shown in Fig. 1. The inoperable-state detection for the individual lamps of each lamp module is executed in parallel for a plurality of lamp modules.

The results (inoperable-state information) of the detection of the inoperable state of the lamps are all collected in the CPU of the control center, and it is not until, for example, a hard copy of the information, such as print-out, is obtained that one can find out which module contains an inoperable lamp. Normally, the body of a large display is often sited remote from the CPU (center terminal) at the center, and the presence or absence of any lamp's inoperable state can be checked only through the center's CPU. This hinders a prompt action to deal with such an inoperable lamp when needed.

Since the inoperable-state detection is carried out in parallel in the individual lamp modules, the checking does not take much time. As the inoperable-state information is collected in the center's CPU, however, it is necessary to transfer the inoperable-state information as serial data to this CPU from the display side, which inevitably takes some time.

The present applicant has developed a technique to execute the inoperable-state detection on the display side in order to overcome the shortcomings, as disclosed in Japanese Patent Application No. 59-278365. The invention taught in this application is directed to a lamp display apparatus having a lamp display screen constituted of a number of display units each having many lamp display elements arranged in a matrix form. This apparatus is characterized in that each display unit has a circuit for comparing the voltage of a lighting circuit for each lamp display element with a reference voltage, determining in an analog manner that lamp display element is abnormal when the former voltage falls below the reference voltage, and displaying the event.

According to such a display apparatus, as a number of display elements are arranged in each display unit, the reference voltage should be set for each unit in light of a variation in the lighting voltage at the normal time due to a variation in the display elements. This job is very troublesome. Further, even one of many display elements in use becomes abnormal or improper due to a change in lighting voltage with time, the abnormality may not be indicated. Furthermore, the conventional display apparatus requires that all the display elements be activated at the time the inoperable-state detection is executed, and cannot perform the inoperable-state detection by activating only arbitrary display elements for the purpose of image display.

It is therefore an object of the present invention to provide an inoperable-state detecting circuit which executes an inoperable-state detection easily and accurately at the site of a display assembly to thereby permit a prompt action against the inoperable state, and a large display apparatus equipped with the same.

It is another object of the present invention to provide a large display apparatus capable of performing an inoperable-state detection even during image display.

To achieve the above objects, an inoperable-state detecting circuit according to the present invention comprises:
lighting signal supplying means for sequentially supplying a lamp lighting signal to a plurality of lamps to sequentially turn on the lamps;

counting means for counting by one upon reception, from each of the lamps, of a lamp-check return signal indicating if the each lamp is properly lit, and outputting a count value;

comparing means for comparing the count value of the counting means with a reference value and outputting a comparison result when supplying of the lamp lighting signal from the lighting signal supplying means is completed; and

discrimination means, provided in a display apparatus, for digitally determining whether or not at least one of the plurality of lamps is inoperable based on the comparison result from the comparing means.

Further, a large display apparatus according to the present invention comprises:

a display section having a plurality of lamp modules arranged in a matrix form each having a plurality of lamps arranged in a matrix form;

lighting signal supplying means, provided for each of the lamp modules of the display section, for sequentially supplying a lamp lighting signal to the plurality of lamps in an associated one of the lamp modules to sequentially turn on the lamps; and

inoperable-state detecting means, provided inside the large display apparatus for each of the lamp modules, for receiving, from each of the lamps of an associated one of the lamp modules, a lamp-check return signal indicating if the each lamp is properly lit and digitally determining whether or not at least one of the lamps in the associated lamp module is inoperable.

This invention can be more fully understood from the following detailed description when taken in conjunction with the accompanying drawings, in which:

Fig. 1 is an exemplary diagram illustrating conventional procedures to detect an inoperable state of lamps included in a lamp module;

Fig. 2 is a front view showing the general structure of a large display apparatus according to the present invention;

Fig. 3 is a cross-sectional view illustrating the general structure of the large display apparatus according to the present invention;

Fig. 4 is a partly cross-sectional view illustrating the general structure of the large display apparatus according to the present invention;

Fig. 5 is a block diagram of one display unit of a large display apparatus equipped with an inoperable-state detecting circuit according to one embodiment of the present invention;

Fig. 6 is a circuit diagram of an inoperable-state detecting circuit in an MGM.,

Fig. 7 is a circuit showing a modification of the inoperable-state detecting circuit;

Fig. 8 is an exemplary diagram illustrating lamp modules arranged to constitute a display unit; and

Fig. 9 is an exemplary diagram illustrating display units arranged to constitute a large display.

To begin with, the general structure of a large display apparatus according to the present invention will be described below referring to the accompanying drawings.

Fig. 2 is a front view of a large display apparatus comprising a base 2 placed on a ground 1, a main assembly 3 provided on the base 2, and a laterally-elongated display section 4 provided at the front of the main assembly 3.

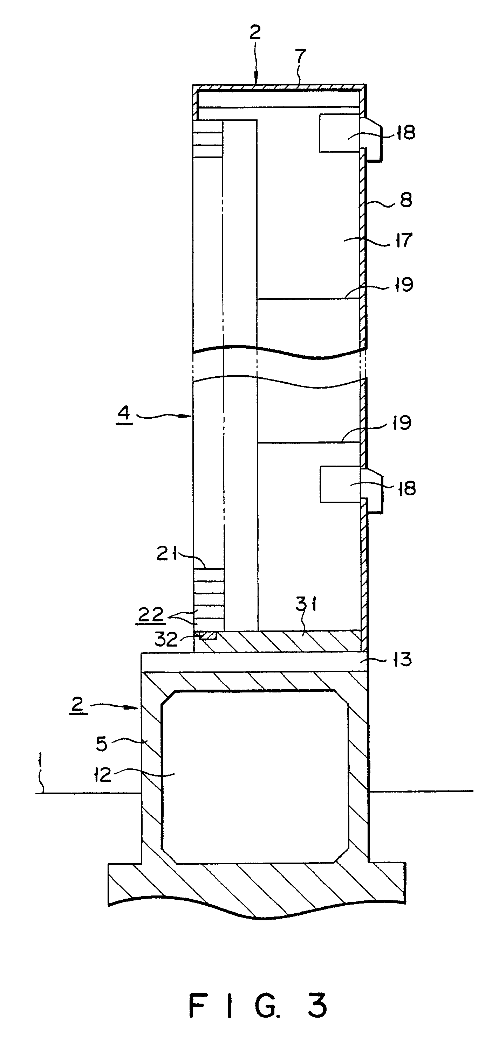

The base 2 has a concrete footing block 5 buried in the ground 1 with an electric chamber 12 formed in the footing block, as shown in Fig. 3.

The main assembly 3 comprises a bottom frame 13 placed on the footing block 5, side frames 6, a rear frame 8 and a top frame 7, and the display section 4 is disposed in the front opening defined by these frames. There are a room 17 defined at the back of the display section 4, and a plurality of ventilation fans 18 provided on the rear frame 8 to ventilate air in the room 17. The room 17 is divided into multiple stages by partitions 19 so that the display section 4 can be maintained stage by stage.

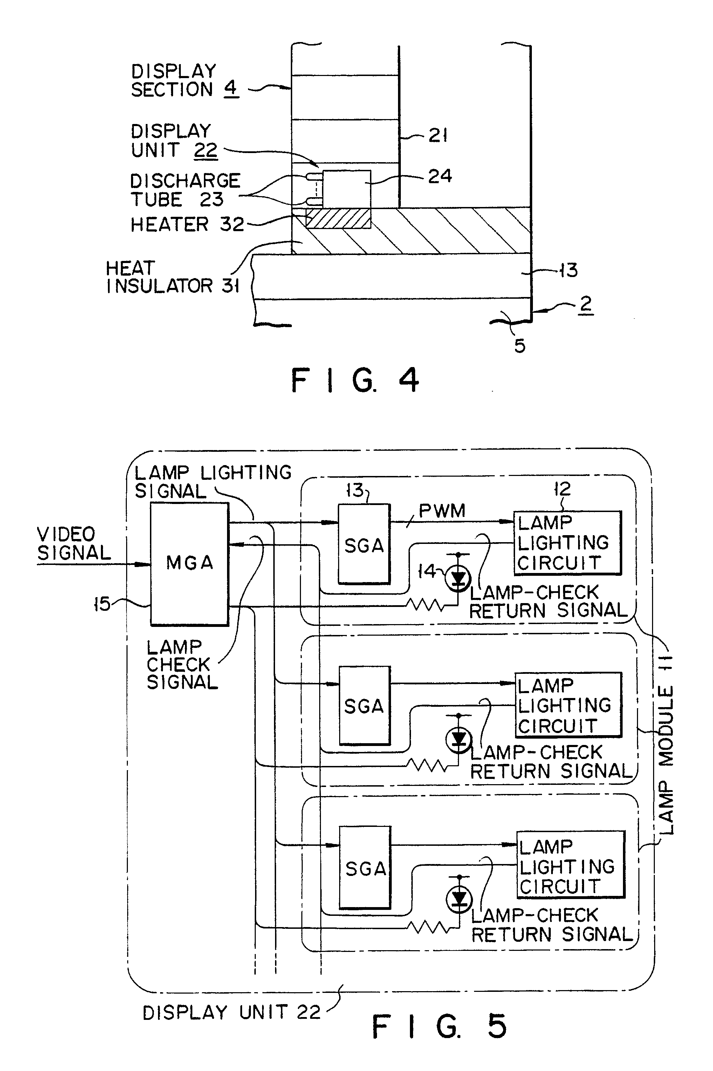

The display section 4 has a plurality of display units 22 arranged in a matrix form, each retained in an associated one of rooms of a lattice-shaped frame 21. As shown in Fig. 4, each display unit 22 has a plurality of discharge tubes 23 as display elements arranged at the front of a unit box 24. These display units 22 are separated into stages like a plurality of stages of the main assembly 3, and display control is executed for each stage by an associated controller.

A heat insulator 31 made of, for example, glass wool is provided between the top of the bottom frame 13 of the main assembly 3 and the bottom of the room 17. A single heater 32 surround by the heat insulator 31 is disposed under each lowermost display unit 22 of the display section 4.

First, a description will be given of the operation of a large display apparatus having the above general structure. The lighting of the individual discharge tubes 23 of each display unit 22 is controlled under the control of a control device, which controls controllers associated with the individual stages, whereby the display section 4 as a whole displays an image and/or characters.

At this time, the ventilation fans 18 and heaters 32 are activated to perform temperature control of the display section 4. More specifically, the ventilation fans 18, when activated, prevents the temperature of the display section 4 from excessively rising due to the heat generated by the discharge tubes 23. Energizing the heaters 32 heats the lower display units 22 from below to raise the temperature of the lower portion of the display section 4 to reduce the temperature difference between the upper and lower portions of the display section 4. In this manner, therefore, even in a cold period in wintertime, particularly, sufficient brightness of the discharge tubes 23 of the lower display units 22 of the display section 4 can be secured so as to prevent uneven brightness from occurring at the upper and lower portions of the display section 4.

The installing of the heat insulator 31 at the lower portion of the main assembly 3 prevents the display section 4 and the room 17 from affected by the heat from the base 2 and keeps the display section 4 and the inside of the room 17 warm to thereby raise the temperature at the lower portion of the display section 4.

Fig. 5 schematically illustrates the structure of one display unit of a large display apparatus equipped with an inoperable-state detecting system according to one embodiment of the present invention. Referring to this diagram, reference numeral "11" denotes a lamp module, reference numeral "12" is a lamp lighting circuit in each lamp module 11, reference numeral "13" is a sub-gate array (hereinafter to be referred to as SGA), reference numeral "14" is an LED which is lit when an inoperable state is detected, and reference numeral "15" is a main gate array (hereinafter to be referred to as MGA).

Each display unit 22 includes eight lamp modules 11. The MGA 15 receives a video signal from a control center (not shown) and sends a lamp lighting signal to each SGA 13; for example, the lamp lighting signal is 8-bit digital data representing the illumination level of each lamp. The MGA 15 has an inoperable-state detecting circuit (which will be described later) for each lamp module 11. The SGA 13 converts the video signal from the MGA 15 into a Pulse Width Modulation (hereinafter to be referred to as PWM) signal and outputs it to the lamp lighting circuit 12. This circuit 12 controls the lighting of the individual lamps based on the PWM signal.

The inoperable-state detection may be invoked by an external CPU (installed in the display's main assembly or by a simple switch without such a CPU. When the inoperable-state detection is invoked, the MGA 15 outputs a lamp lighting signal to each lamp module 11 in order to sequentially turn on the lamps. Based on this lamp lighting signal, the SGA 13 sends a predetermined PWM signal to the lamp lighting circuit 12 to turn on the lamps in the lamp module 11 one by one. The lamp lighting circuit 12 then returns a lamp-check return signal, which indicates if a lamp is properly lit or inoperable, to the associated inoperable-state detecting circuit located in the MGA 15.

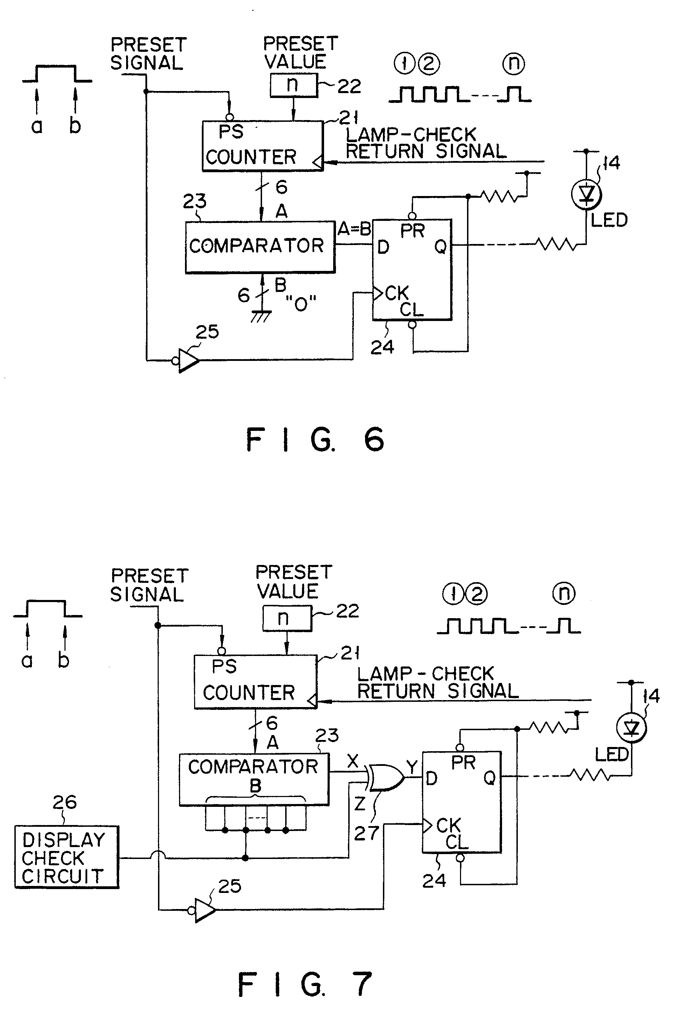

Fig. 6 presents a circuit diagram of the inoperable-state detecting circuit provided in the MGA 15 of Fig. 5 for each lamp module. Referring to this diagram, reference numeral "21" is a counter, reference numeral "22" is a preset value setting unit for setting an initial value for the counter 21, reference numeral "23" is a comparator, reference numeral "24" is a latch, and reference numeral "25" is an inverter; the LED 14 is the same as is shown in Fig. 5. When the inoperable-state detection is invoked, a preset signal rises to "H" (High) level from "L" (Low) level as indicated by "a". When the preset signal is at "L" level, the negative logic terminal PS of the counter 21 becomes "H," so that a preset value n is always set in this counter by the preset value setting unit. In this embodiment, one lamp module consists of 64 lamps and the present value n is therefore "64." When the preset signal rises as indicated by "a," the lamps of each lamp module are lit one by one as already described with reference to Fig. 5. Every time a lamp is lit, the lamp lighting circuit 12 returns the lamp-check return signal (one clock signal) to the associated counter 21 in the MGA 15. This counter 21 decrements the content every time a lamp is lit and the lamp-check return signal is received. When the 64 lamps in each lamp module are all normal, therefore, there should be 64 lamp-check return signals or clocks returned. As the initial value "64" of the counter 21 is decremented by one for each clock, it would be "0" at the end. The value of this counter 21 is input to a terminal A of the comparator 23 whose terminal B is supplied with "0." When the 64 lamps are all properly lit, the condition A = B is satisfied and an "H" signal is output to the latch 24 from the comparator 23.

As the preset signal falls to "L" at the timing "b" thereafter, it is inverted by the inverter 25 to be an "H" level signal, which is in turn input to a terminal CK of the latch 24. As a result, the "H" level signal from the comparator 23 is latched in the latch 24 and a terminal Q of the latch 24 also becomes "H," inhibiting the LED 14 from being lit. The OFF state of the LED 14 indicates that no abnormality exists in the associated lamp module or all the lamps in the lamp module have been properly lit.

If one or more inoperable lamps are present in any lamp module 11, the number of the lamp-check return signals returned from this lamp module would be "63" or less. Consequently, the condition A = B of the comparator 23 is not satisfied. When the checking of all the lamps is completed or when the preset signal falls at "b," the output of the comparator 23 becomes "L" and an "L" signal is latched in the latch 24. This sets the terminal Q of the latch 24 to "L," turning on the LED 14. It can be considered that any lamp module whose LED 14 is lit has at least one inoperable lamp. As the LED 14 is located in the lamp module 11 as shown in Fig. 5, the inoperable state present in this lamp module can promptly be checked or recognized on the display side.

Referring to Fig. 7, a modification of the above inoperable-state detecting circuit will be described below.

The same reference numerals as used for the circuit elements of the circuit shown in Fig. 6 are used to denote the identical or corresponding elements in Fig. 7, thus omitting their description.

A display check circuit 26 is designed in such a manner that in executing an inoperable-state detection with no image being displayed, the display check circuit 26 sends an "L" level output in response to a signal from a control center (not shown) and sends an "H" level output otherwise. The output of the display check circuit 26 is sent to the comparator 23 and to a Z input terminal of an exclusive-OR circuit (hereinafter to be referred to as EX-OR) 27 as a logic processor. The output of the comparator 23 is supplied to an X input terminal of the EX-OR 27 whose output Y is input to a terminal D of the latch circuit 24. The LED 14 is the same as is shown in Fig. 5. First, in a case where no image is displayed, when the inoperable-state detection is invoked, the output of the display check circuit 26 becomes "L" and the preset signal rises to "H" from "L" as indicated by "a." Since the subsequent operation is the same as the one described with reference to Fig. 6, the description will be omitted. In this modification, however, when the 64 lamps are all normal, the comparator 23 outputs an "H" level signal to the input terminal X of the Ex-OR 27. At this time, since an "L" input is given to the input terminal Z of the EX-OR 27, an "H" output is sent to the latch 24 from the output terminal Y.

With an image being displayed, the lighting signal output from the MGA 15 in accordance with the video signal produced from the control center (not shown) is supplied to the lamps, the output of the display check circuit 26 becomes "H," and the preset signal rises to "H" from "L" as indicated by "a." When the preset signal is at "L" level, the negative logic terminal PS of the counter 21 becomes "H," so that a preset value n, which is "64," is always set in this counter by the preset value setting unit. When the preset signal rises as indicated by "a," an arbitrary lamp is lit according to the lighting signal. Every time a lamp is lit, the lamp lighting circuit 12 returns the lamp-check return signal (one clock signal) to the associated counter 21 in the MGA 15. This counter 21 decrements the content every time lighting a lamp is detected and the lamp-check return signal is returned. As some of the 64 lamps in the lamp module are lit (in general, all the video signals are hardly black display signals), one or more lamp-check return signals return. As the initial value "64" of the counter 21 is decremented by one for each clock (generally, all the video signals are hardly black display signals), it would be "63" or less at the end. The value of this counter 21 is input to the terminal A of the comparator 23 whose terminal B is supplied with "1." When any of the 64 lamps is normal, the condition A = B is not satisfied and an "L" signal is output to the input terminal X of the EX-OR 27 from the comparator 23. At this time, an "H" input is input to the input terminal Z of the EX-OR 27, so that an "H" signal is output to the latch 24 from the output terminal Y.

As the preset signal falls to "L" at the timing "b" thereafter, it is inverted by the inverter 25 to be an "H" level signal, which is in turn input to the terminal CK of the latch 24. As a result, the "H" level signal from the comparator 23 is latched in the latch 24 and the terminal Q of the latch 24 also becomes "H," inhibiting the LED 14 from being lit. The OFF state of the LED 14 indicates that no abnormality exists in the associated lamp module or all the lamps in the lamp module have been properly lit.

If the lamp module 11 becomes inoperable and all the lamps are not lit, the number of the lamp-check return signals returned from this lamp module would be "0.". Consequently, the condition A = B of the comparator 23 is satisfied. When the checking of all the lamps is completed or when the preset signal falls at "b," the output of the comparator 23 becomes "L," the output of the output terminal Y of the EX-OR 27 becomes "H" as the input terminals X and Z are respectively "L" and "H," permitting an "L" signal to be latched in the latch 24. This sets the terminal Q of the latch 24 to "L," turning on the LED 14. It can be considered that any lamp module whose LED 14 is lit has a damaged lamp lighting circuit or control circuit. As the LED 14 is located in the lamp module 11 as shown in Fig. 5, the inoperable state present in this lamp module can promptly be checked or recognized on the display side.

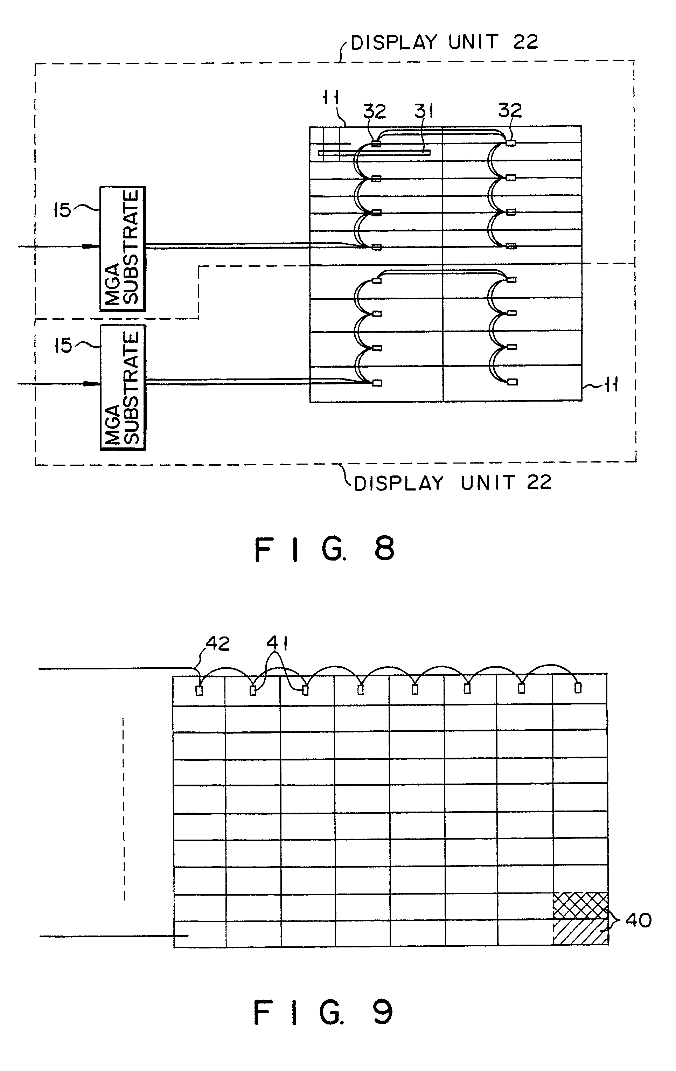

Fig. 8 is an exemplary diagram illustrating eight lamp modules 11 arranged to constitute one display unit 22. One lamp module 11 has 64 lamps arranged in a 16 × 16 matrix. One display unit 22 has the eight lamp modules 11 arranged in a 2 × 4 matrix; Fig. 8 shows two display units 22 placed one on the other. Substrates 31 of the lamp module 11 are sequentially connected to a MGA substrate 15 through connectors 32. The LED 14, which is lit when an inoperable state is detected, is located on the substrate 31 and can be viewed from the back of the large display.

Fig. 9 is an exemplary diagram illustrating the display units 22 arranged in an 8 × 10 matrix to constitute a large display. One block 40 indicates one lamp unit. Reference numeral "41" denotes a MGA substrate for each lamp unit 40 and reference numeral "42" denotes its connecting line.

As described above, according to the present invention, the circuit for detecting an inoperable state of a lamp is provided in the display apparatus and the inoperable-state detection is digitally performed in order for the individual. display elements in each lamp module, thus ensuring simple and accurate inoperable-state detection. Further, the inoperable-state detection can be performed even while an image is displayed.

## Claims

1. An inoperable-state detecting circuit for a large display apparatus characterized by comprising:
lighting signal supplying means (15) for sequentially supplying a lamp lighting signal to a plurality of lamps to sequentially turn on said lamps;
counting means (21) for counting by one upon reception, from each of said lamps, of a lamp-check return signal indicating if said each lamp is properly lit, and outputting a count value;
comparing means (23) for comparing said count value of said counting means (21) with a reference value and outputting a comparison result when supplying of said lamp lighting signal from said lighting signal supplying means (15) is completed; and
discrimination means (24, 27), provided in a display apparatus, for digitally determining whether or not at least one of said plurality of lamps is inoperable based on said comparison result from said comparing means (23).

2. The inoperable-state detecting circuit according to claim 1, characterized in that said discrimination means (24, 27) includes means (14) for visually indicating that at least one of said plurality of lamps is inoperable.

3. The inoperable-state detecting circuit according to claim 1, characterized in that said discrimination means (24, 27) includes a discrimination section for performing a first discrimination in a case where all of said plurality of lamps are lit and a second discrimination in a case where only arbitrary ones of said plurality of lamps are lit, and said inoperable-state detecting circuit further includes detection means (26) for detecting whether or not it is a video display state in which only those of said plurality of lamps which are given a video display instruction are lit, whereby said discrimination means (24, 27) executes either the first or second discrimination in accordance with a detection output of said detection means (26).

4. The inoperable state detecting circuit according to claim 3, characterized in that said discrimination section includes an exclusive-OR circuit (27).

5. A large display apparatus characterized by comprising:
a display section (22) having a plurality of lamp modules (11) arranged in a matrix form each having a plurality of lamps arranged in a matrix form;
lighting signal supplying means (15), provided for each of said lamp modules (11) of said display section (22), for sequentially supplying a lamp lighting signal to said plurality of lamps in an associated one of said lamp modules (11) to sequentially turn on said lamps; and
inoperable-state detecting means (24), provided inside said large display apparatus for each of said lamp modules (11), for receiving, from each of said lamps of an associated one of said lamp modules (11), a lamp-check return signal indicating if said each lamp is properly lit and digitally determining whether or not at least one of said lamps in said associated lamp module (11) is inoperable.

6. The large display apparatus according to claim 5, characterized in that said inoperable-state detecting means (21) includes counting means for counting by one upon reception, from each of said lamps, of said lamp-check return signal indicating if said each lamp is properly lit, and outputting a count value, comparing means (23) for comparing said count value of said counting means (21) with a reference value and outputting a comparison result when supplying of said lamp lighting signal from said lighting signal supplying means (15) is completed, and discrimination means (24), provided in a display apparatus, for digitally determining whether or not at least one of said plurality of lamps is inoperable based on said comparison result from said comparing means (23).

7. The inoperable-state detecting circuit according to claim 5, characterized in that said discrimination means (24, 27) includes a discrimination section for performing a first discrimination in a case where all of said plurality of lamps are lit and a second discrimination in a case where only arbitrary ones of said plurality of lamps are lit, and said inoperable-state detecting circuit further includes detection means (26) for detecting whether or not it is a video display state in which only those of said plurality of lamps which are given a video display instruction are lit, whereby said discrimination means (24, 27) executes either the first or second discrimination in accordance with a detection output of said detection means (26).

8. The large display apparatus according to claim 7, characterized in that said discrimination section includes an exclusive-OR circuit (27).

9. The large display apparatus according to claim 5, characterized by further comprising means (13) for converting said lamp lighting signal from said lighting signal supplying means (15) into a pulse width modulation signal and sequentially supplying said pulse width modulation signal to said lamps in each lamp module (11).

10. The large display apparatus according to claim 5, characterized by further comprising display means (14) provided for each of said lamp modules (11), for presenting visual display of each discrimination result for each of said lamp modules (11).

LAMP IS LIT

F I G. 1

F I G. 2

F I G. 3

DISPLAY SECTION 4
DISPLAY UNIT 22
DISCHARGE TUBE 23
HEATER 32
HEAT INSULATOR 31
21
24
13
2
5

F I G. 4

LAMP LIGHTING SIGNAL
VIDEO SIGNAL
MGA
15
LAMP CHECK SIGNAL
13
SGA
PWM
12
LAMP LIGHTING CIRCUIT
14
LAMP-CHECK RETURN SIGNAL
SGA
LAMP LIGHTING CIRCUIT
LAMP-CHECK RETURN SIGNAL
SGA
LAMP LIGHTING CIRCUIT
LAMP-CHECK RETURN SIGNAL
LAMP MODULE 11
DISPLAY UNIT 22

F I G. 5

F I G. 6

F I G. 7

F I G. 8

F I G. 9